# EUROPEAN PATENT APPLICATION

(11) **EP 2 916 536 A1**
(43) Date of publication of application: **09.09.2015**
(21) Application number: 13851398.1
(22) Date of filing: 25.10.2013
(51) Int. Cl.: H04N 5/225, H01L 27/14, H01L 31/02, H04N 5/33, H04N 5/335, H04N 5/361

(54) **IMAGE CAPTURE DEVICE**

(30) Priority: 02.11.2012 JP 2012243108
(71) Applicant: Sumitomo Electric Industries, Ltd., Osaka 541-0041 (JP)
(72) Inventor: SAITOH, Tatsuhiko, Yokohama-shi Kanagawa 244-8588 (JP); YAMAGUCHI, Hideyuki, Yokohama-shi Kanagawa 244-8588 (JP); KOBAYASHI, Ryoichi, Yokohama-shi Kanagawa 244-8588 (JP)
(74) Representative: Hoffmann Eitle
(86) International application number: PCT/JP2013/078980
(87) International publication number: WO 2014/069365

(57) **Abstract**

A preset temperature, which is an optimum control temperature for a semiconductor light-receiving element corresponding to the temperature of a space A, in which an analog circuit board 5 having a semiconductor light-receiving element 43 mounted thereon is disposed, is measured in advance, and is stored in an optimum-preset-temperature storage element 605. Then, the temperature of the space A is measured by a space temperature sensor 9, and by referring to the optimum-preset-temperature storage element 605, information concerning the preset temperature corresponding to the measured temperature of the space A is obtained. Then, the semiconductor light-receiving element 43 is cooled by using an electronic cooling element 49 so that the temperature of the semiconductor light-receiving element 43 to be measured by a temperature sensor for the semiconductor light-receiving element 43 will be the preset temperature indicated by the obtained information. With this arrangement, even if the environmental temperature, such as the temperature of a board, is changed, it is possible to control the temperature of the semiconductor light-receiving element 43 with higher precision, thereby suppressing a variation in the dark current value.

## Description

### Technical Field

The present invention relates to an image capture device.

### Background Art

In a digital camera which performs an imaging operation to obtain still images and video images, a light-receiving element (image sensor) is used for performing an imaging operation in which light reflected by an object to be imaged and incident on a plurality of two-dimensionally arranged pixels is received, the received incident light is converted into an electric signal, and the resultant electric signal is output. It is known that, generally, a light-receiving element for an infrared region is used in a state in which it is cooled to a low temperature by means of electronic cooling since the value (dark current) of a signal output from the light-receiving element when light is blocked is large at room temperature (for example, see Japanese Unexamined Patent Application Publication No. 2000-115596).

In this case, when the temperature of the light-receiving element is changed, the dark current value is also changed. More specifically, when the temperature of the light-receiving element is increased, a resulting image is likely to become brighter, and conversely, when the temperature of the light-receiving element is decreased, a resulting image is likely to become darker. In particular, in the case of hyperspectral imaging, a temperature change of the light-receiving element directly influences a spectrum to be obtained. Accordingly, in order to obtain images with a stabilized precision, it is desirable to reduce a variation in a dark current.

### Summary of Invention

### Technical Problem

It is an object of the present invention to provide an image capture device in which it is possible to reduce a variation in a dark current to a smaller level.

### Solution to Problem

In order to achieve the object, the present invention provides an image capture device including: a light-receiving element that receives light from an object to be imaged; a casing in which the light-receiving element is disposed; a space temperature sensor that measures a temperature of a space, which is part of an inside portion of the casing, in which the light-receiving element is disposed; a light-receiving-element temperature sensor that measures a temperature of the light-receiving element; cooling means for cooling the light-receiving element; temperature-information storage means for storing therein information concerning an association between a temperature of the space and a preset temperature, the information being used for maintaining the temperature of the light-receiving element at a constant value; and control means for controlling the cooling means. The cooling means cools the light-receiving element so that the temperature of the light-receiving element to be measured by the light-receiving-element temperature sensor will be a predetermined temperature. The control means obtains, on the basis of the temperature of the space measured by the space temperature sensor, the preset temperature corresponding to the temperature of the space by referring to the temperature-information storage means, and controls the cooling means so that the temperature of the light-receiving element to be measured by the light-receiving-element temperature sensor will be the preset temperature.

In the image capture device according to the present invention, the space may be formed by inner walls of the casing and a board on which the light-receiving element is mounted, and the space temperature sensor may be mounted on a surface of the board facing the space. Alternatively, the space temperature sensor may be mounted on an inner wall of the casing.

### Advantageous Effects of Invention

According to the present invention, there is provided an image capture device in which it is possible to reduce a variation in a dark current to a smaller level.

### Brief Description of Drawings

Figure 1 is a schematic view illustrating the configuration of a digital camera, which is an image capture device according to an embodiment of the present invention.
Figure 2 is a conceptual view illustrating the internal configuration of a light-receiving element included in the digital camera shown in Fig. 1.
Figure 3 is a block diagram illustrating the configuration of circuits included in the digital camera shown in Fig. 1.
Figure 4 is a graph showing, when the board temperature is changed, how the camera output changes when light is blocked under the condition that the exposure time is 9 ms.
Figure 5 is a graph showing, when the board temperature is changed, how the camera output changes when light is blocked under the condition that the exposure time is 30 ms.
Figure 6 shows the relationship between the board temperature and the optimum preset temperature for a light-receiving element such that, when the environmental temperature is 25°C, the temperature of the light-receiving element is -77°C.

### Description of Embodiments

An embodiment of the present invention will be described below in detail with reference to the accompanying drawings. In the description of the drawings, the same elements are designated by identical reference numerals, and an explanation of the same element will be given only once.

As a result of intensive and extensive research, the present inventors have found that a change in the environmental temperature around a light-receiving element influences a cooling effect produced on the light-receiving element. More specifically, it has been discovered that it is appropriate that the cooling of a light-receiving element is controlled on the basis of the temperature around the light-receiving element in order to reduce a variation in the temperature of the light-receiving element.

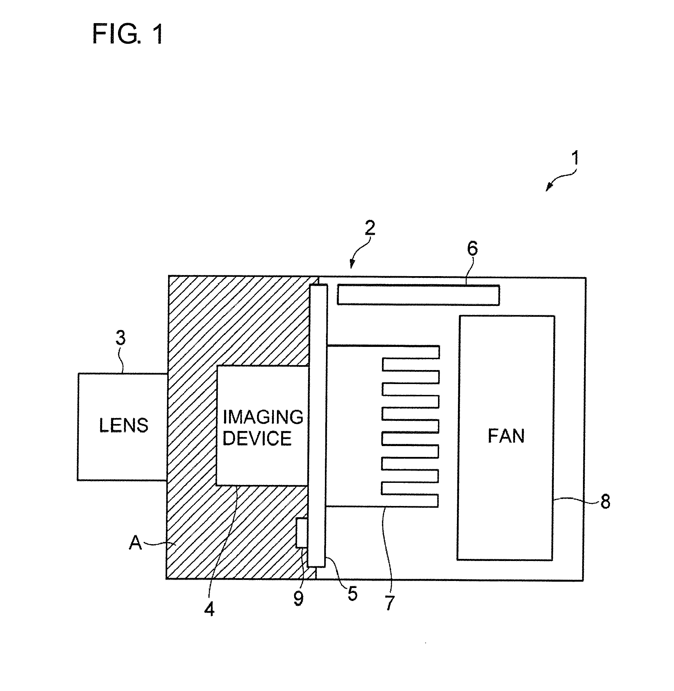

Figure 1 is a schematic view illustrating the configuration of a digital camera 1, which is an image capture device according to an embodiment of the present invention. The digital camera 1 includes a casing 2, a lens 3, an imaging device 4, an analog circuit board 5, a digital circuit board 6, a cooling fin 7, a fan 8, and a space temperature sensor 9. Examples of an image capture device to which the present invention is applicable are general digital cameras and hyperspectral cameras. The hyperspectral cameras obtain a reflectance spectrum indicating the characteristics and physical properties of an object to be imaged.

The digital camera 1 receives, by using the imaging device 4 provided within the casing 2, light which strikes the lens 3 from the outside of the casing 2. The digital camera 1 has a function of performing processing such as analog-to-digital (A/D) conversion and correction on the received light by using the circuits disposed on the analog circuit board 5 and the digital circuit board 6, and outputs image information to a monitor or the like. The analog circuit board 5 is a board on which the imaging device 4 and the space temperature sensor 9 are mounted, and also, a circuit for performing analog processing on information concerning light received by the imaging device 4 and then performing A/D conversion on the information is mounted. The digital circuit board 6 is a board on which a digital circuit for performing digital processing on information supplied from the analog circuit board 5 and then outputting the information to the outside is mounted.

The imaging device 4 is mounted on one principal surface (front side) of the analog circuit board 5. On the other principal surface (back side) opposite the front side, the cooling fin 7 for cooling individual devices and circuits including the imaging device 4 fixed on the analog circuit board 5 is mounted. The fan 8 for cooling the cooling fin 7 is disposed within the casing 2. The fan 8 is driven so as to cool the cooling fin 7, thereby releasing heat from the imaging device 4. On the surface of the analog circuit board 5 facing a space A, the space temperature sensor 9 is mounted. The space temperature sensor 9 measures the temperature of the space A (the region indicated by the hatched portion in Fig. 1) to which the imaging device 4 is exposed. The temperature of the space A measured by this space temperature sensor 9 is used for controlling the cooling of the imaging device 4. This will be discussed later.

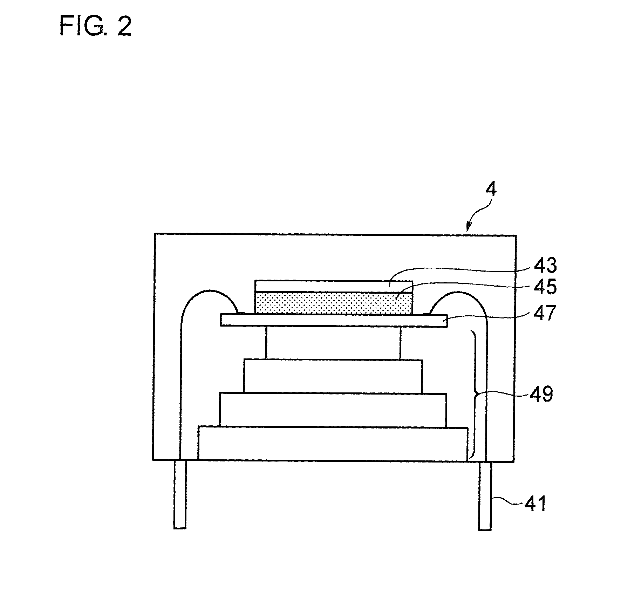

Figure 2 is a conceptual view illustrating the internal configuration of the imaging device 4 included in the digital camera 1. The imaging device 4 is fixed on the analog circuit board 5 by means of connecting pins 41. In the imaging device 4, a semiconductor light-receiving element (light-receiving element) 43, a read out integrated circuit (ROIC) 45, a relay substrate 47, and an electronic cooling element (cooling means) 49 are stacked on each other in this order from the side of the lens 3.

The semiconductor light-receiving element 43 has a function of converting a signal of received light into an electric signal. As the semiconductor light-receiving element 43, for example, two-dimensionally arranged HgCdTe (MCT) light-receiving elements or type-II quantum-well light-receiving elements are used. It is assumed that, in the digital camera 1, the semiconductor light-receiving element 43 receives near-infrared light having a wavelength range of 0.75 µm to 3.0 µm.

The ROIC 45 has a function of reading out an electric signal generated as a result of the semiconductor light-receiving element 43 receiving light and also has a function of monitoring the temperature of the semiconductor light-receiving element 43. The relay substrate 47 has a function of transferring an electric signal read by the ROIC 45 to the analog circuit board 5. As the electronic cooling element 49, for example, a Peltier element is used, and the electronic cooling element 49 has a function of cooling the ROIC 45 and the semiconductor light-receiving element 43 through the relay substrate 47. The electronic cooling element 49 is driven so that it will be set to be a preset temperature specified by a light-receiving-element temperature control circuit of a camera controller, which will be discussed later.

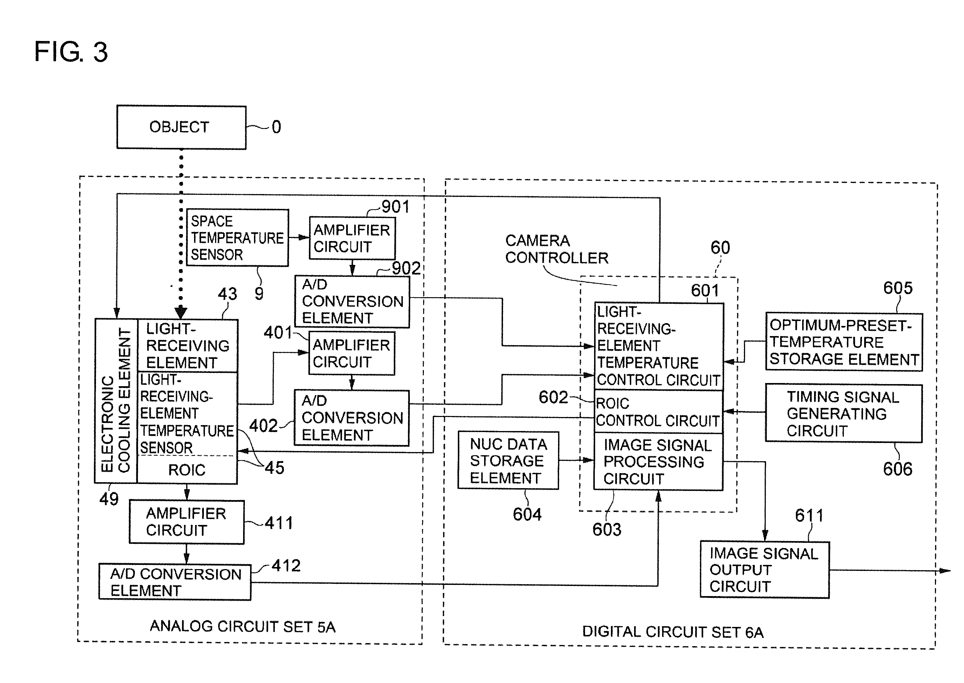

Figure 3 is a block diagram illustrating the configuration of circuits included in the digital camera 1. In Fig. 3, an analog circuit set 5A and a digital circuit set 6A are shown. Circuits and elements disposed within the analog circuit set 5A are circuits and elements mounted on the analog circuit board 5. Circuits and elements disposed within the digital circuit set 6A are circuits and elements mounted on the digital circuit board 6.

Light from an object O to be imaged is received by the semiconductor light-receiving element 43 of the analog circuit set 5A. A current which is output from the semiconductor light-receiving element 43 as a result of receiving light from the object O is read by the ROIC 45, and data items concerning several tens of thousands of pixels are serially output as a voltage signal on a time-series basis while synchronizing with a timing signal, which will be discussed later. This voltage signal is amplified by an amplifier circuit 411 and is converted into a digital signal by an A/D conversion element 412. The digital signal is then supplied to an image signal processing circuit 603.

Additionally, information concerning the temperature of the light-receiving element measured by a light-receiving-element temperature sensor included in the ROIC 45 is amplified by an amplifier circuit 401 and is converted into a digital signal by an A/D conversion element 402. The digital signal is then supplied to a light-receiving-element temperature control circuit 601. Similarly, information concerning the temperature of the space A measured by the space temperature sensor 9 is amplified by an amplifier circuit 901 and is converted into a digital signal by an A/D conversion element 902. The digital signal is then supplied to the light-receiving-element temperature control circuit 601.

The digital circuit set 6A mounted on the digital circuit board 6 includes a camera controller (control means) 60, a Non-Uniformity Correction (NUC) data storage element 604, an optimum-preset-temperature storage element (temperature information storage means) 605, a timing signal generating circuit 606, and an image signal output circuit 611. The camera controller 60 includes the light-receiving-element temperature control circuit 601, an ROIC control circuit 602, and the image signal processing circuit 603.

The light-receiving-element temperature control circuit 601 obtains temperature information concerning the space A measured by the space temperature sensor 9, and reads, from the optimum-preset-temperature storage element 605, the optimum preset temperature for the light-receiving element 43 corresponding to the temperature indicated by the obtained temperature information. The light-receiving-element temperature control circuit 601 obtains temperature information concerning the semiconductor light-receiving element 43 from the light-receiving-element temperature sensor (ROIC 45), and performs feedback control of the cooling capacity (a current value or a voltage value) of the electronic cooling element 49 so that the temperature of the light-receiving element will coincide with the optimum preset temperature.

The ROIC control circuit 602 is a circuit that generates timing signals, such as Clock, Lsync, and Fsync, requested by the ROIC, on the basis of a signal from the timing signal generating circuit 606, and then sends these timing signals and an analog voltage signal necessary for controlling the ROIC to the ROIC, thereby controlling the operation of the ROIC 45. Clock is a timing signal, which is a basis of the operation performed by the ROIC, Lsync is a timing signal indicating the head of one line, and Fsync is a timing signal indicating the head of one frame.

The image signal processing circuit 603 is a circuit that corrects an image signal obtained by imaging the object O and outputs the corrected image signal. More specifically, the image signal processing circuit 603 has a function of obtaining a signal indicating the object O sent from the ROIC 45 and also obtaining information for performing image correction from the NUC data storage element 604, and generating an image signal corrected on the basis of the obtained information. The signal generated by the image signal processing circuit 603 is converted into an output format, such as National Television System Committee (NTSC) or camera link, by the image signal output circuit 611 and is output to the outside (for example, a monitor).

The NUC data storage element 604 is an element that stores therein information concerning the correction of an image signal performed in the image signal processing circuit 603. Examples of the information stored in the NUC data storage element 604 are information concerning the correction corresponding to the characteristics of each pixel and information for correcting for initial defects which are identified in advance.

The setting of the temperature of the semiconductor light-receiving element 43 will be described below. Generally, a semiconductor light-receiving element having sensitivity to a near-infrared region, in particular, to a wavelength region exceeding 1.7 µm has a small band gap and is thus easily excited by phonons. Accordingly, the dark current of the semiconductor light-receiving element becomes large at room temperature, and thus, it is difficult to utilize such a semiconductor light-receiving element as an imaging element. Accordingly, the semiconductor light-receiving element is used in a state where it is cooled to a low temperature (for example, -60°C or lower). In the digital camera 1, too, by cooling the semiconductor light-receiving element 43 by using the electronic cooling element 49, the semiconductor light-receiving element 43 can be maintained at a low temperature.

When the temperature of the semiconductor light-receiving element 43 is changed, the dark current value is also changed, thereby changing the level of a signal (current value) output from the semiconductor light-receiving element 43. When the temperature of the semiconductor light-receiving element 43 is increased, a resulting image is likely to become brighter, and when the temperature of the semiconductor light-receiving element 43 is decreased, a resulting image is likely to become darker. In whichever case it is, a color hue or a color tone of an image of an object is changed, thereby failing to obtain a clear and sharp image.

In order to obtain an image, which is less vulnerable to an influence of a change in the dark current value, by using the semiconductor light-receiving element 43, it is necessary to maintain the semiconductor light-receiving element 43 at a constant temperature. In particular, in hyperspectral imaging, which requires a higher-precision output value than imaging performed by a general digital camera, temperature control with higher precision is demanded, since a change in the dark current value caused by a variation in the temperature of light-receiving element produces a great influence on imaging data as noise. More specifically, in the case of hyperspectral imaging, it is desirable to control the temperature of a semiconductor light-receiving element within about ±0.1 °C in order to increase the precision of a spectrum to be obtained.

Information concerning the temperature of the semiconductor light-receiving element 43 is obtained by the light-receiving-element temperature control circuit 601 after the amplifier circuit 401 has amplified an electric signal (output voltage) from the light-receiving-element temperature sensor included in the ROIC 45. If the temperature variation of the semiconductor light-receiving element 43 is within about ±0.1°C, the output voltage varies about ±0.2 mV. However, in general electronic circuits, the noise level is about several mV. Accordingly, in order to precisely read a variation within ±0.2 mV, it is necessary to reduce the influence of noise by performing processing, such as taking the average value of values obtained by performing several thousands of measurements. However, even if the precision in measuring the temperature of a light-receiving element is improved by performing such average processing, if the temperature of the analog circuit board 5, which is a control board, is changed, the circuit constant is slightly changed. Then, the actual control temperature is changed.

For example, it is now assumed that, when the preset temperature for the semiconductor light-receiving element 43 is set to be -60°C by the control circuit, the output voltage from the light-receiving-element temperature sensor included in the ROIC 45 is 500 mV and is amplified in the amplifier circuit 401 by ten times, with the result that the amplified output voltage is 5 V. In this case, the light-receiving-element temperature control circuit 601 controls the electronic cooling element 49 so that the amplified output voltage can be maintained at a constant value of 5 V.

It is assumed that the amplification factor of the amplifier circuit 401 has become slightly smaller due to a change in the temperature of the analog circuit board 5. More specifically, it is assumed that if the output voltage from the light-receiving-element temperature sensor is 500 mV, the amplified output voltage is reduced from 5 V to 4.9 V due to a decreased amplification factor. Even in this case, the light-receiving-element temperature control circuit 601 controls the electronic cooling element 49 so that the amplified output voltage will be 5 V. Thus, the electronic cooling element 49 is controlled so that the output value from the light-receiving-element temperature sensor will be 510 mV. That is, even if the light-receiving-element temperature control circuit 601 adjusts settings so that the output voltage amplified by the amplifier circuit 401 can be maintained at a constant value, the temperature of the semiconductor light-receiving element 43 is changed under the influence of the actual temperature of the board. This may change the dark current value of the semiconductor light-receiving element 43, thereby decreasing the precision of an obtained image.

A description has been given above such that the amplification factor of the amplifier circuit 401, which amplifies a voltage value output from the light-receiving-element temperature sensor, is changed while being dependent on the temperature of the analog circuit board 5. In reality, however, a parameter which varies depending on the temperature of the analog circuit board 5 may be, not only the amplification factor of the amplifier circuit 401, but also the drive voltage of the light-receiving-element temperature sensor or the space temperature sensor 9. It is possible that a variation in such parameters caused by a change in the temperature of the board may change the temperature of the semiconductor light-receiving element 43, and as a result, the dark current value may drift. That is, the temperature of the analog circuit board is changed due to a change in the environmental temperature around the semiconductor light-receiving element 43 during an imaging operation, thereby causing the above-described problems. Accordingly, in order to increase the precision of, in particular, hyperspectral images, it is necessary to suppress a variation in the dark current value in a case in which the environmental temperature is changed.

Thus, in the digital camera 1, the light-receiving-element temperature control circuit 601 determines the preset temperature for cooling the light-receiving element in accordance with the environmental temperature, thereby suppressing a variation in the dark current value caused by a change in the environmental temperature.

The environment around the semiconductor light-receiving element 43 is the space A surrounded by the casing 2 and by the analog circuit board 5 on which the semiconductor light-receiving element 43 is mounted. Accordingly, the preset temperature, which is the optimum control temperature, for the semiconductor light-receiving element corresponding to the temperature of the space A is measured in advance, and is stored in the optimum-preset-temperature storage element 605. Then, the temperature of the space A is measured by using the space temperature sensor 9, and by referring to the optimum-preset-temperature storage element 605, information concerning the preset temperature corresponding to the measured temperature of the space A is obtained. Then, the semiconductor light-receiving element 43 is cooled by the electronic cooling element 49 so that the temperature of the semiconductor light-receiving element 43 to be measured by the temperature sensor for the semiconductor light-receiving element 43 will be the preset temperature indicated by the obtained information. With this arrangement, even if the environmental temperature, such as the temperature of the board, is changed, it is possible to control the temperature of the semiconductor light-receiving element 43 with higher precision, thereby suppressing a variation in the dark current value.

With this configuration, even if the temperature of the space in the digital camera 1 is changed, the light-receiving element is cooled so that the temperature of the light-receiving element can be maintained at a constant value, thereby appropriately suppressing a variation in the dark current value. This will be discussed below through the following example.

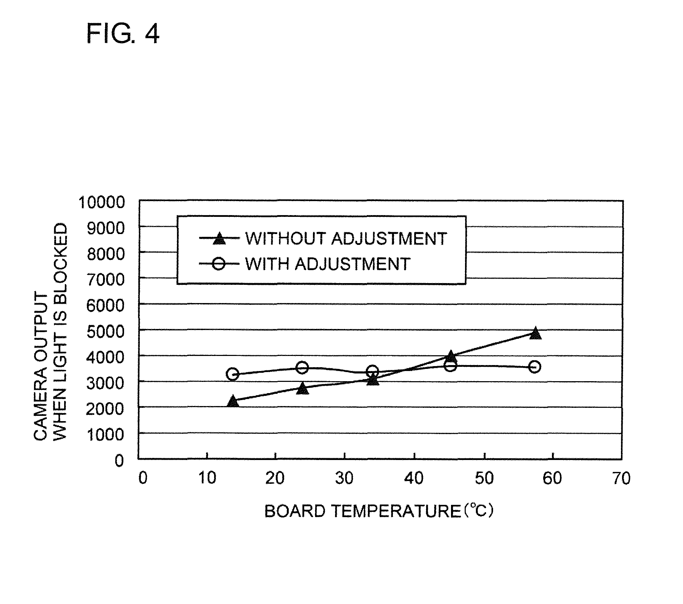

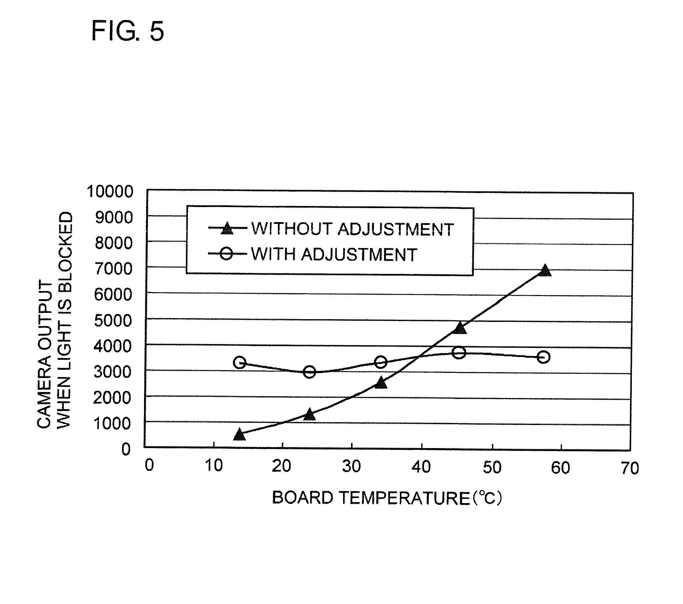

Figures 4 and 5 show the results of evaluating the relationship between the board temperature (the temperature of the analog circuit board 5) and the camera output when light is blocked by changing the temperature of the space A. The results shown in Figs. 4 and 5 include the result when controlling for the temperature of the semiconductor light-receiving element is adjusted by using the above-described method (with adjustment) and the result when controlling for the temperature of the semiconductor light-receiving element is not adjusted by using the above-described method (without adjustment).

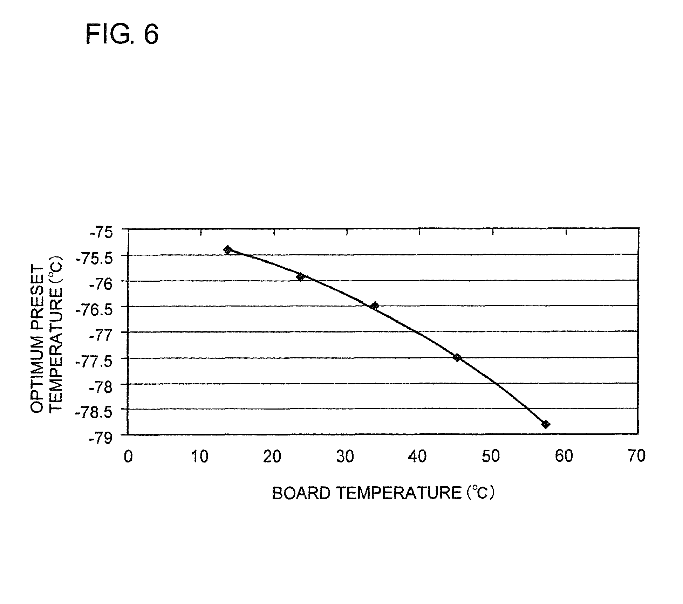

Figure 4 shows the results of evaluating the relationship between the temperature of the analog circuit board (the temperature of the space A) and the camera output when light is blocked by changing the environmental temperature to 0, 10, 20, 30, and 40°C under the conditions that the frame rate is 100 Hz and the exposure time is 9 ms. In this case, the temperature of the space A corresponding to the environmental temperature was changed to 14, 24, 34, 45, and 57. The term "without adjustment" means that a known method was employed, that is, the semiconductor light-receiving element was cooled so that the temperature of the semiconductor light-receiving element measured by the temperature sensor for the semiconductor light-receiving element would be maintained at a constant value (-77°C). The term "with adjustment" means that the temperature of the space A was measured by the space temperature sensor 9, and the semiconductor light-receiving element was cooled so that the temperature of the semiconductor light-receiving element would be the optimum preset temperature determined from Fig. 6. The term "the camera output when light is blocked" refers to the value output from the semiconductor light-receiving element in the state in which the lens is shielded from light, that is, the value corresponding to the dark current value.

Figure 5 shows the results of evaluating the relationship between the temperature of the analog circuit board (the temperature of the space A) and the camera output when light is blocked by changing the environmental temperature to 0, 10, 20, 30, and 40°C under the conditions that the frame rate is 30 Hz and the exposure time is 30 ms. Without adjustment, the semiconductor light-receiving element 43 was controlled so that the temperature of the semiconductor light-receiving element 43 would be maintained at a constant value of -77°C. With adjustment, the semiconductor light-receiving element 43 was controlled so that the temperature of the semiconductor light-receiving element 43 would be maintained at the optimum temperature determined from Fig. 6.

Figure 6 shows an example of the relationship between the board temperature (the temperature of the space A) and the optimum preset temperature for the light-receiving element when the optimum preset temperature for the light-receiving element is changed as a function of the board temperature so that the output when light is blocked will be constant. Figure 6 shows a case, by way of example, in which, when the environmental temperature is 25°C (the board temperature is 40°C), the temperature of the light-receiving element is -77°C. By changing the preset temperature for the light-receiving element as a function of the board temperature, a variation in the output when light is blocked was suppressed, as shown in Figs. 4 and 5.

In Fig. 4 showing the camera output under the condition that the exposure time is 9 ms, a variation in the camera output when light is blocked with adjustment is smaller than that without adjustment, and the effectiveness of the present invention can be validated. However, the effect of the present invention appears to be relatively small. On the other hand, in Fig. 5 showing the camera output under the condition that the exposure time is 30 ms, a variation in the camera output when light is blocked without adjustment is large, and thus, the effect of the present invention appears to be great. In this manner, by using the adjusting method of this embodiment, in whichever case of Fig. 4 or 5, a variation in the camera output when light is blocked with adjustment with respect to the board temperature is smaller than that without adjustment. Thus, the effectiveness of the present invention can be validated. As the exposure time is longer, a variation in the camera output when light is blocked with respect to the environmental temperature is larger. Accordingly, controlling for the temperature of the semiconductor light-receiving element according to the embodiment is particularly effective under imaging conditions that the exposure time is long, as in the example shown in Fig. 5.

While an embodiment of the present invention has been described above, it is to be understood that the present invention is not restricted to the above-described embodiment, and various modifications may be made. For example, in the above-described embodiment, the space temperature sensor 9 for measuring the space A is mounted on the analog circuit board 5. Alternatively, the space temperature sensor 9 may be mounted on an inner wall of the casing 2. Additionally, in the above-described embodiment, a digital camera having sensitivity to a near-infrared region has been discussed. However, the above-described temperature control method for a light-receiving element is also applicable to digital cameras having sensitivity to another wavelength range.

### Industrial Applicability

The present invention is useful for obtaining hyperspectral images in an infrared light region.

## Claims

1. An image capture device comprising:
a light-receiving element that receives light from an object to be imaged;
a casing in which the light-receiving element is disposed;
a space temperature sensor that measures a temperature of a space, which is part of an inside portion of the casing, in which the light-receiving element is disposed;
a light-receiving-element temperature sensor that measures a temperature of the light-receiving element;
cooling means for cooling the light-receiving element so that the temperature of the light-receiving element to be measured by the light-receiving-element temperature sensor will be a predetermined temperature;
temperature-information storage means for storing therein information concerning an association between a temperature of the space and a preset temperature, the information being used for maintaining the temperature of the light-receiving element at a constant value; and
control means for obtaining, on the basis of the temperature of the space measured by the space temperature sensor, the preset temperature corresponding to the temperature of the space by referring to the temperature-information storage means, and for controlling the cooling means so that the temperature of the light-receiving element to be measured by the light-receiving-element temperature sensor will be the preset temperature.

2. The image capture device according to Claim 1, wherein:
the space is formed by inner walls of the casing and a board on which the light-receiving element is mounted; and
the space temperature sensor is mounted on a surface of the board facing the space.

3. The image capture device according to Claim 1, wherein the space temperature sensor is mounted on an inner wall of the casing.
